# EUROPEAN PATENT APPLICATION

(11) **EP 2 216 814 A2**
(43) Date of publication of application: **11.08.2010**
(21) Application number: 09167108.1
(22) Date of filing: 03.08.2009
(51) Int. Cl.: H01L 25/07

(54) **Power semiconductor device and manufacturing method therefor**

(30) Priority: 05.02.2009 JP 2009025171
(71) Applicant: Mitsubishi Electric Corporation, Chiyoda-ku Tokyo 100-8310 (JP)
(72) Inventor: Sudo, Shingo, Tokyo 100-8310 (JP); Ota, Tatsuo, Tokyo 100-8310 (JP); Yoshida, Hiroshi, Tokyo 100-8310 (JP); Shikano, Taketoshi, Tokyo 100-8310 (JP)
(74) Representative: Prüfer & Partner GbR European Patent Attorneys

(57) **Abstract**

A power semiconductor device includes a semiconductor element (20), a plastic housing (10), which covers the semiconductor element (20) and has a plastic housing concave (12) that is formed lower than the other part of the outer wall of the plastic housing (10), and a terminal (15), which is electrically connected to the semiconductor element (20) within the plastic housing (10) and extended from the plastic housing concave (12) to the outside of the plastic housing (10). The position of the terminal (15) within the plastic housing concave (12) gives positional displacement information about the terminal (15).

## Description

### Background of the Invention

### Field of the Invention

The present invention relates to a power semiconductor device having a semiconductor element, which is covered with a plastic housing, and a terminal, which is extended out of the plastic housing. The present invention also relates to a method of manufacturing such a power semiconductor device.

### Background Art

A semiconductor element such as a power MOSFET and IGBT (Insulated Gate Bipolar Transistor) is mounted on a circuit pattern formed on a substrate. The semiconductor element is not limited to a power MOSFET and IGBT, but includes a diode and other elements used in a power semiconductor device. Wiring connections are made as needed between semiconductor elements and between a semiconductor element and a circuit pattern.

A column electrode, which is a part of a terminal that connects a semiconductor element to the outside, is soldered or otherwise fastened to the circuit pattern. After the column electrode is fixed, transfer molding is used to seal the semiconductor element and column electrode with resin. As the column electrode is used to connect the semiconductor element to the outside, a part of the column electrode needs to be exposed to the outside after transfer molding.

After a plastic housing is formed by transfer molding, an electrode called a pin electrode is extended out of the plastic housing and connected to the column electrode to complete a power semiconductor device. The pin electrode and column electrode are collectively referred to as terminals because they are similar in functionality and both used to connect the semiconductor element to the outside. The power semiconductor device generally includes a plurality of terminals. Therefore, the terminals are arranged so as to provide an insulation distance between the terminals in consideration of the spatial distance and creepage distance between the terminals. A power semiconductor device configured to provide enhanced reliability and quality consistency is described in JP-A-2001-223321 and JP-A-2007-184315.

As a power semiconductor device handles a high voltage, it is necessary to verify during its manufacturing process that the distance between terminals is not shorter than the insulation distance. More specifically, manufacturing variation unavoidably arises so that the terminals may be displaced more or less from their designed positions. Thus, it is necessary to verify that the insulation distance is provided between the terminals even when such positional displacement occurs.

Further, when the number of terminals is increased, productivity decreases because it takes a long time to measure the distance between the terminals. Meanwhile, if the distance between the terminals is increased to facilitate the measurement of the distance between the terminals, it is difficult to reduce the size of the power semiconductor device.

The above problem is remarkable particularly if the power semiconductor device has a heatsink that is exposed from a surface of the plastic housing. More specifically, the terminals are protected against electrical influence from the heatsink as they are arranged concentratively only on a surface opposing the surface from which the heatsink is exposed. This increases the number of inter-terminal distance measurement points and the time required for measurement, thereby decreasing productivity. Further, when the terminals are arranged in a concentrated manner, an electrically conductive adhesive used to glue down the terminals provides electrical conduction between the terminals, thereby degrading the insulation characteristics.

Furthermore, air remains between the terminals and resin when a transfer molding process is performed to form the plastic housing. This also degrades the insulation characteristics of the terminals.

### SUMMARY OF THE INVENTION

The present invention has been made to solve the above problem. An object of the present invention is to provide a power semiconductor device that improves the insulation characteristics of its terminals and makes it easy to determine the amount of positional displacement of each terminal. Another object of the present invention is to provide a method of manufacturing such a power semiconductor device.

According to one aspect of the invention, a power semiconductor device includes a semiconductor element, a plastic housing, which covers the semiconductor element and has a plastic housing concave that is formed lower than the other part of the outer wall of the plastic housing, and a terminal, which is electrically connected to the semiconductor element within the plastic housing and extended from the plastic housing concave to the outside of the plastic housing. The position of the terminal within the plastic housing concave gives positional displacement information about the terminal.

According to another aspect of the present invention, a power semiconductor device includes a semiconductor element, which is disposed on a substrate, a plastic housing, which covers the substrate and the semiconductor element, and a terminal, which is electrically connected to the semiconductor element within the plastic housing and extended from a principal surface of the plastic housing to the outside of the plastic housing. A plastic housing groove, which is a groove lower than the other part, is formed in a portion of the principal surface of the plastic housing that is positioned at a predetermined distance from the terminal. The depth of the plastic housing groove is such that the substrate and the semiconductor element are not exposed to the outside. The plastic housing groove is formed by transfer molding.

According to still another aspect of the present invention, there is provided a power semiconductor device manufacturing method comprising the steps of: performing a transfer molding process to form a plastic housing concave, which is lower than the other part of the outer wall of a plastic housing, and form the plastic housing so that a column electrode is partially exposed from the plastic housing concave; judging in accordance with the positional relationship between the plastic housing concave and the column electrode whether the amount of positional displacement of the column electrode is in compliance with a standard; and injecting resin or adhesive into the plastic housing concave while a pin electrode extended out of the plastic housing is connected to the column electrode so as to position a connection point within the plastic housing concave.

Other and further objects, features and advantages of the invention will appear more fully from the following description.

### Brief Description of the Drawings

FIG.1 is a perspective external view of a power semiconductor device according to the first embodiment of the present invention;
FIG.2 is a perspective view illustrating the internal structure of a plastic housing shown in FIG. 1;
FIG.3 is a cross-sectional view taken along line I-I in FIG. 1;
FIG.4 illustrates a transfer molding process;
FIG.5 shows the plastic housing that is molded and removed from the molds;
FIG.6 is a perspective external view of a power semiconductor device according to the second embodiment;
FIG.7 is a cross-sectional view taken along line II-II in FIG. 6;
FIG.8 is a set of plan views showing the injection of molding resin into a cavity formed by the upper mold;
FIG.9 shows a groove formation upper mold convex51 formed in parallel with the flowing direction of the molding resin;
FIG.10 shows a groove formation upper mold convex51 formed in perpendicularly to the flowing direction of the molding resin;
FIG.11 is an enlarged cross-sectional view illustrating the column electrode and its vicinity;
FIG.12 is a plan view of the star-shaped pin electrode;
FIG.13 shows a front view of the pin electrode;
FIG.14 shows a needle-eye type pin electrode;
FIG.15 is a perspective external view of a power semiconductor device according to the third embodiment;
FIG.16 is a cross-sectional view taken along line III-III in FIG. 15;
FIG.17 is a perspective external view of the power semiconductor device according to the fourth embodiment;
FIG.18 is a cross-sectional view taken along line IV-IV in FIG. 17; and
FIG.19 is a flowchart illustrating a method of manufacturing the power semiconductor device according to the fourth embodiment.

### Detailed Description of the Preferred Embodiments

### First Embodiment

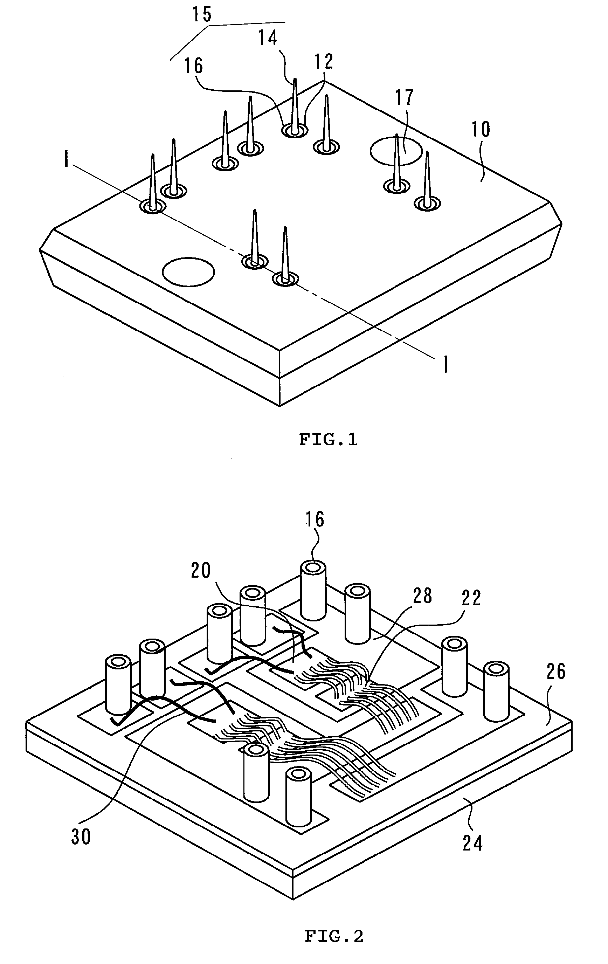

A first embodiment of the present invention will now be described with reference to FIGS. 1 to 5. Like materials and elements are designated by the same reference numerals and may not be redundantly described. This is also true for the other embodiments of the present invention.

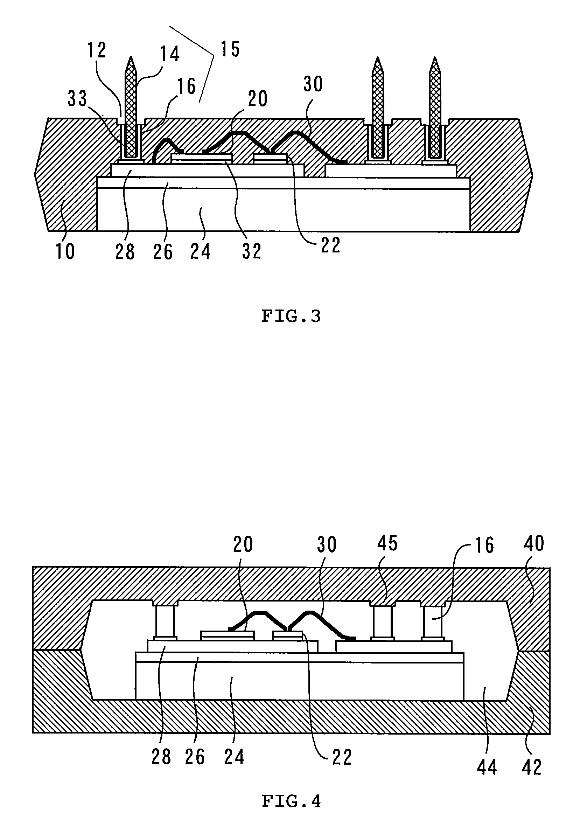

FIG. 1 is a perspective external view of a power semiconductor device according to the first embodiment of the present invention. FIG. 2 is a perspective view illustrating the internal structure of a plastic housing shown in FIG. 1. FIG. 3 is a cross-sectional view taken along line I-I in FIG. 1. The configuration of the power semiconductor device according to the present embodiment will be described below with reference to FIGS. 1 to 3. The external structure of the power semiconductor device according to the present embodiment is such that a pin electrode 14 and a part of a column electrode 16 are extended out of a plastic housing 10 as shown in FIG. 1. It is assumed that the plastic housing 10 measures 76 mm high, 45 mm wide, and 8 mm thick. However, the present invention is not limited to such dimensional constraints. Further, the column electrode 16 and pin electrode 14 are collectively referred to as the terminals 15.

The terminals 15 are extended out of the plastic housing 10 through a plastic housing concave 12, which is formed lower than the other part of the plastic housing 10. The plastic housing concave 12 is provided independently for each of a plurality of terminals 15 that are arranged as shown in FIG. 1. In the present embodiment, the plastic housing concave 12 is formed 100 µm lower than the outer wall of the plastic housing 10. Further, a counterbored mounting hole 17 is formed in the plastic housing 10 to mount, for instance, a heatsink in the power semiconductor device.

As shown in FIG. 2, which shows the interior of the plastic housing, an IGBT 20 and a Fw-Di (free-wheeling diode) 22 are soldered or otherwise fastened to a circuit pattern 28 that is formed on a heatsink 24. The heatsink 24 is a plate that is mainly made, for instance, of aluminum and approximately 2 mm in thickness. It is thermally connected to the IGBT 20 and Fw-Di 22 and used to dissipate heat from them. To prevent the circuit pattern 28 from conducting electricity to the heatsink 24, the circuit pattern 28 is attached to the heatsink 24 via a thermally-conductive insulation adhesive layer 26 that is obtained by mixing epoxy resin, which functions as an adhesive material, with alumina or other insulation material having relatively high thermal conductivity. The circuit pattern 28 is formed with a material that contains, for instance, copper, which exhibits high electrical conductivity.

The column electrode 16 is mounted upright on the aforementioned circuit pattern 28. The column electrode 16 is mounted so as to electrically connect the IGBT 20 and Fw-Di 22 (hereinafter may be referred to as the semiconductor elements) to the outside. The column electrode 16 is soldered or otherwise connected to the circuit pattern 28. Further, the column electrode 16 has a hole in the surface to be exposed out of the plastic housing 10 so that it can be connected to the aforementioned pin electrode 14. FIG. 1 shows that the open surface of the hole in the column electrode 16 is partially exposed to the front surface.

To achieve a designed circuit configuration, the IGBT 20, Fw-Di 22, and circuit pattern 28 are connected as needed with wiring 30. An ultrasonic wire bonding or other similar method is used to make connections with the wiring 30. As is the case with a common power semiconductor device, the back surface of the IGBT 20 is a collector whereas the back surface of the Fw-Di 22 is a cathode. Both of these elements are connected to the circuit pattern 28. The interior of the plastic housing 10 shown in FIG. 1 is configured as described above.

The connection between the column electrode 16 and pin electrode 14 will be described below with reference to FIG. 3. The pin electrode 14 is inserted into the hole in the column electrode 16 to establish the connection between the pin electrode 14 and column electrode 16. This connection is reinforced by an electrically conductive adhesive that is applied to the inner wall of the hole in the column electrode 16.

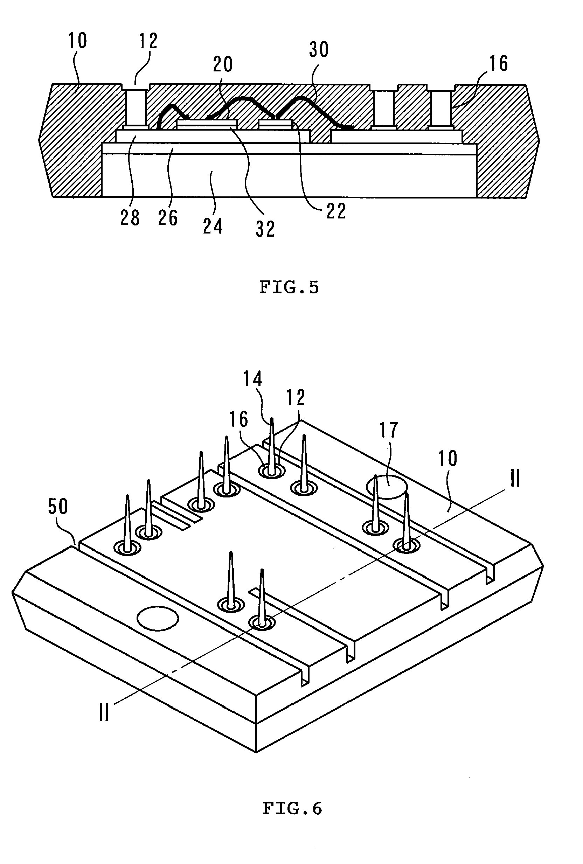

A method of manufacturing the power semiconductor device according to the present embodiment will now be described with reference to FIGS. 4 and 5. After the structure shown in FIG. 2 (this structure is hereinafter referred to as the insert structure) is formed, a process for forming the plastic housing 10 is initiated to protect the structure, for instance, against water and foreign matter. The plastic housing 10 is formed by a transfer molding method.

FIG. 4 illustrates a transfer molding process. As shown in FIG. 4, the aforementioned insert structure is positioned within a cavity 44 that is formed by an upper mold 40 and a lower mold 42. An upper mold convex 45, which protrudes above the other part, is formed on the inner wall of the upper mold 40. Mold clamping is performed with the upper mold convex 45 brought into contact with the upper surface of the column electrode 16 and the heatsink 24 brought into contact with the inner wall of the lower mold 42. Next, epoxy resin or other molding resin is filled into the cavity 44, and then pressurized and heated to mold the plastic housing 10. FIG. 5 shows the plastic housing 10 that is molded and removed from the molds.

Next, the pin electrode 14 is mounted in the manner described with reference to FIG. 3 to complete the power semiconductor device.

At a design stage, the terminals of a power semiconductor device are generally positioned so that the inter-terminal distance is not shorter than the insulation distance. However, the column electrode may be displaced from its design position depending, for instance, on the dimensional accuracy of the insert structure, the dimensional accuracy of a jig for soldering the column electrode to the circuit pattern, and the dimensional accuracy of a solder resist for preventing solder from contacting irrelevant areas. In view of such circumstances, the inter-terminal distance is often checked during a power semiconductor device manufacturing process to verify that the inter-terminal distance is not shorter than the insulation distance. This verification process is referred to as the positional displacement inspection. The positional displacement inspection is essential particularly for a power semiconductor device that handles a high voltage.

The positional displacement inspection is complicated in most cases because it is frequently conducted with reference to the external shape of the plastic housing 10 and with the aid of a measuring jig. Further, the time required for inspection increases with an increase in the number of terminals, thereby decreasing productivity. Particularly when the heatsink is exposed from the plastic housing so that an adequate creepage distance needs to be provided between the heatsink and terminals, the inspection is further complicated because the terminals have to be arranged in a concentrated manner. In addition, particularly when the terminals are arranged in a concentrated manner, the electrically conductive adhesive used to join the column electrode and pin electrode, which constitute each terminal, may scatter to adversely affect inter-terminal insulation. Meanwhile, if the power semiconductor device is designed to provide a sufficient inter-terminal distance for the purpose of simplifying the positional displacement inspection, the power semiconductor device has to be excessively large in size.

The above problem is solved when the power semiconductor device and manufacturing method according to the present embodiment are used. More specifically, the positional displacement inspection can be completed simply by comparing the relative positions of the plastic housing concave 12, which is formed for each of a plurality of terminals 15, and the terminal 15 extended from the plastic housing concave 12. This eliminates the necessity of using the aforementioned measuring jig. Therefore, the positional displacement inspection is simplified to provide increased productivity. Further, as the positional displacement inspection is facilitated, it is possible to reduce the size of the power semiconductor device without having to increase its size.

For example, as far as the terminal 15 is extended out of the plastic housing concave 12, it is possible to define the spread of the plastic housing concave 12 so as to permit the judgment on whether the insulation characteristics can be maintained, and conduct the positional displacement inspection to merely check whether the terminal 15 is extended out of the plastic housing concave 12. In this instance, if any product has a terminal that is extended from a flat portion of the outer wall of the plastic housing and not extended from the plastic housing concave, it can be detected as a defective product. This makes it easy to determine whether the power semiconductor device is ready for shipment.

Further, the plastic housing concave 12 is formed independently for each of the plurality of terminals 15. Therefore, even when the electrically conductive adhesive 33 leaks out of the hole in the column electrode 16, it stays on the inner wall of the plastic housing concave 12. This prevents the electrically conductive adhesive 33 from acting as a conductor between one terminal 15 and another.

The present embodiment assumes that the positional displacement information about a terminal 15 is obtained by conducting the positional displacement inspection to check whether the terminal 15 is extended from the plastic housing concave 12. However, the present invention is not limited to the use of such a method. The spread of the plastic housing concave 12 is not specifically defined as far as the positional relationship between the plastic housing concave 12 and the terminal 15 extended from the plastic housing concave 12 indicates whether a predetermined permissible amount of positional displacement is exceeded.

The power semiconductor device according to the present embodiment is configured so that the plastic housing concave 12 is formed independently for each terminal 15. However, the present invention is not limited to such a configuration. The plastic housing concave 12 need not always be formed for each terminal as far as the terminals are positioned apart from each other to prevent the electrically conductive adhesive from acting as a conductor between the terminals and the amount of positional displacement of each terminal can be determined with ease.

The present embodiment assumes that the plastic housing concave 12 of the power semiconductor device remains as is as shown in FIG. 1. However, the present invention is not limited to such a configuration. More specifically, the plastic housing concave 12 may alternatively be filled with resin after the positional displacement inspection. This protects the joint between the column electrode 16 and pin electrode 14. This alternative configuration is particularly effective when the power semiconductor device is used in a highly humid or severely vibrating environment.

The present embodiment assumes that the upper mold 40 used in the transfer molding process is provided with the upper mold convex 45. However, the present invention is not limited to the use of such an upper mold structure. An alternative is to use an upper mold 40 without the upper mold convex 45, form a flat surface through which a plastic housing terminal is to be extended, and then make a plastic housing concave by performing a mechanical process or energy beam process. This alternative is advantageous in that it eliminates the necessity of providing the upper mold with the upper mold convex and makes it possible to use the upper mold universally.

The present embodiment assumes that the pin electrode 14 is glued to the column electrode 16 with the electrically conductive adhesive 33. However, the present invention is not limited to the use of such an adhesion method. More specifically, a male-threaded pin electrode may be inserted into a female-threaded, nut-shaped column electrode for fastening purposes. Another alternative is to use a terminal without a pin electrode. More specifically, a portion of an unbored column electrode that is exposed from the plastic housing may be connected to the outside via a solder ball or electrically conductive adhesive. Similarly, a soldering, welding, or other connection method may be used, instead of using an adhesive, to establish the connection between the column electrode and the pin electrode or between the column electrode and the outside. As described above, the present embodiment is **characterized in that** the positional displacement inspection can be conducted with ease. Therefore, the materials, dimensions, and configuration described in connection with the present embodiment may be changed as appropriate as far as the above-mentioned characteristics are maintained. For example, the semiconductor elements are not limited to the IGBT and Fw-Di.

### Second Embodiment

A second embodiment of the present invention will now be described with reference to FIGS. 6 to 14. FIG. 6 is a perspective external view of a power semiconductor device according to the second embodiment. The power semiconductor device according to the second embodiment, which is shown in FIG. 6, differs from the power semiconductor device according to the first embodiment in that plastic housing grooves 50 are formed in the front surface of the plastic housing 10.

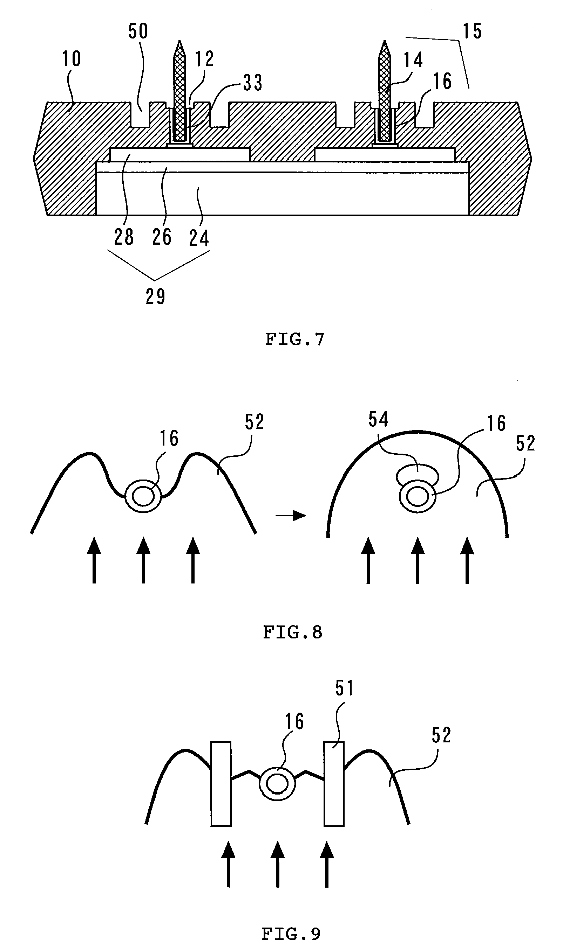

FIG. 7 is a cross-sectional view taken along line II-II in FIG. 6. As shown in FIG. 7, the plastic housing grooves 50 are positioned on the right and left sides of a terminal 15 so that the terminal 15 is sandwiched between the plastic housing grooves 50. A heatsink 24, a thermally-conductive insulation adhesive layer 26, and a circuit pattern 28 are collectively referred to as the substrate 29 (which may also be referred to as the metal base substrate). The depth of the plastic housing grooves 50 is about half the thickness of molding resin on the substrate 29. In other words, the bottom of the plastic housing grooves 50 is positioned substantially midway between the substrate 29 and the outer wall of the plastic housing 10. The plastic housing grooves 50 are approximately 1 mm in width.

A method of manufacturing the power semiconductor device according to the present embodiment will now be described. The method of manufacturing the power semiconductor device according to the present embodiment will be described by explaining about only the differences from the method of manufacturing the power semiconductor device according to the first embodiment. Each plastic housing groove 50 is made together with the plastic housing concave 12 when the plastic housing is formed by the transfer molding method. In other words, the upper mold used for transfer molding is similar to the upper mold 40 described with reference to FIG. 4, but provided with an upper mold convex for forming the plastic housing groove 50 (which is referred to as the groove formation upper mold convex) in addition to the upper mold convex 45.

The meaning of performing a transfer molding process with the above-described upper mold will now be described with reference to a comparative example shown in FIG. 8. The upper mold used in the comparative example is not provided with the groove formation upper mold convex. FIG. 8 is a set of plan views showing the injection of molding resin into a cavity formed by the upper mold. These plan views especially illustrate the flow of molding resin 52 near the column electrode 16. As indicated by the lefthand plan view in FIG. 8, a portion of the molding resin 52 that flows directly toward the column electrode 16 decreases its flow rate because it is blocked by the column electrode 16. On the other hand, a portion of the molding resin 52 that flows at a distance from the column electrode 16 does not decrease its flow rate and moves in the direction of the arrows in the drawing.

Because of the flow rate difference described above, the molding resin 52 flowing at a distance from the column electrode 16 may surround the column electrode 16 with some air trapped. As a result, the air 54 may remain in contact with the column electrode 16, as indicated by the righthand plan view in FIG. 8, even after termination of transfer molding, thereby causing an adhesion failure. An adhesion failure may incur an insulation failure. It is conceivable that such a failure may be avoided by decreasing the rate of molding resin injection into the cavity or by injecting the molding resin into the cavity with a vacuum produced in the cavity. However, both of the above-mentioned methods will incur decreased productivity or require the use of a vacuum device or other additional production facility.

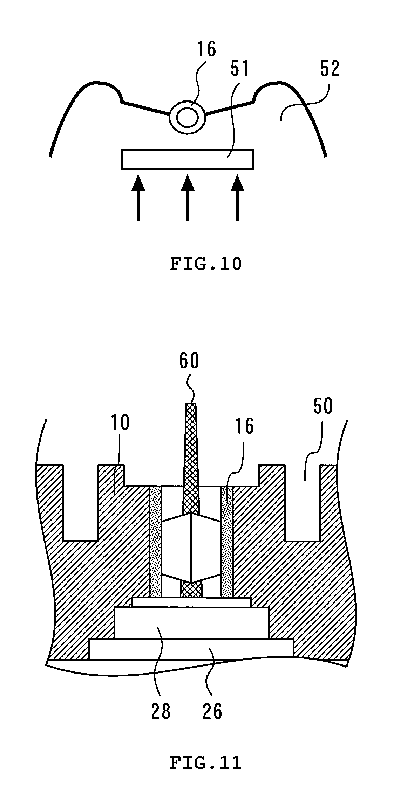

However, the method of manufacturing the power semiconductor device according to the present embodiment makes it possible to solve the above problem. Effects produced by the present embodiment will now be described with reference to FIGS. 9 and 10. FIGS. 9 and 10 are plan views showing the injection of molding resin 52 into the cavity, as is the case with FIG. 8. These plan views illustrate the flow of molding resin 52. The groove formation upper mold convex 51, which correlates with the plastic housing groove 50 as described earlier, controls the flow rate of molding resin 52 not only at a location close to the column electrode 16 but also at a location far from the column electrode 16. More specifically, if the groove formation upper mold convex 51 is formed in parallel with the flowing direction of the molding resin 52 as shown in FIG. 9, the flow path for the molding resin 52 is narrowed to minimize the amount of trapped air. If, on the other hand, the groove formation upper mold convex 51 is formed perpendicularly to the flowing direction of the molding resin 52 as shown in FIG. 10, the flow rate of the molding resin 52 decreases within a large area around the column electrode 16 to minimize the amount of trapped air.

Further, as is obvious from FIG. 6, which shows the distribution of the plastic housing groove 50, each groove formation upper mold convex 51 is positioned only near the column electrode 16. Therefore, although the flow rate of the molding resin 52 is decreased near the column electrode 16, such a flow rate decrease insignificantly affects the time required for filling the entire cavity with the molding resin. Thus, the productivity remains unimpaired. Consequently, a highly reliable power semiconductor device can be manufactured at a high productivity while overcoming the negative effect of trapped air.

The following explanation deals with three effects that are produced by the power semiconductor device with the plastic housing groove 50 after it is completed. The first effect is that the plastic housing and column electrode will not become detached from their positions when a heatsink is mounted. A heatsink or the like is mounted in a mounting hole 17 shown in FIG. 6. If, for instance, a heatsink is screwed down to the power semiconductor device, a tightening force may be applied to the power semiconductor device to bend it. This tightening force can detach the plastic housing and column electrode from their positions. However, the configuration according to the present embodiment can solve the above problem because it allows the plastic housing groove 50 to absorb the tightening force. If the plastic housing for the power semiconductor device is large in size, shaped as a rectangular parallelepiped or shaped substantially as a rectangular parallelepiped, and provided with long sides and short sides, an enhanced detachment prevention effect is obtained when the plastic housing groove is made orthogonally to the long sides.

The second effect is that the creepage distance will increase. When the plastic housing groove 50 is made between the terminals, the insulation distance can be provided with ease due to an increase in the inter-terminal creepage distance. Thus, the terminals can be arranged with the inter-terminal planar distance rendered shorter than when there is no plastic housing groove 50. This makes it possible to reduce the size of the power semiconductor device.

The third effect is that the strength of the joint between the pin electrode and column electrode increases in a situation where the pin electrode is press-fit into the column electrode for connection purposes. In some cases, the pin electrode is press-fit into the column electrode to establish the connection between them. The use of such a connection method is advantageous in that the use of an adhesive or other bonding agent is not required, but may result in connection strength inadequacy. More specifically, the press-fit pin electrode slightly scrapes the inner wall of the hole in the column electrode to increase the width of the hole so that the established connection is maintained by the force of repulsion from the inner wall of the column electrode. However, as the column electrode is laterally sandwiched by the molding resin, the aforementioned width of the hole does not adequately increase. Therefore, sufficient repulsion force is not obtained. Further, if the employed configuration increases the press-fitting force to obtain adequate connection strength, the plastic housing 10 may crack or otherwise become damaged.

However, the configuration according to the present embodiment is such that the plastic housing groove 50 is positioned near the column electrode 16. Therefore, press-fitting the pin electrode into the column electrode 16 adequately increases the width of the hole in the column electrode 16. Thus, the force of repulsion from the inner wall of the hole is adequate for the pin electrode. This makes it possible to provide increased connection strength between the pin electrode and column electrode.

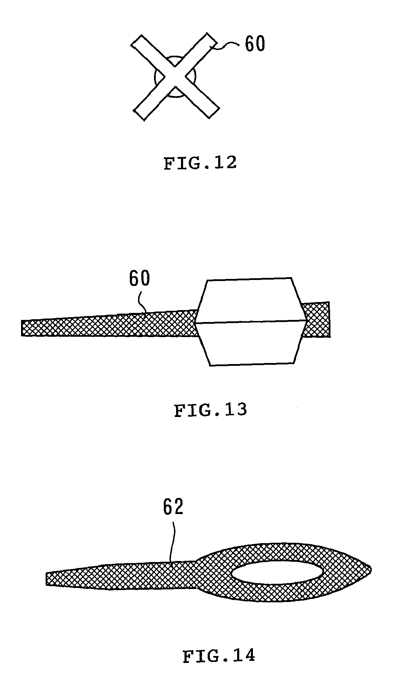

FIG. 11 illustrates the pin electrode that is press-fit into its position as described above. FIG. 11 is an enlarged cross-sectional view illustrating the column electrode 16 and its vicinity. Referring to FIG. 11, a star-shaped pin electrode 60 is used as the pin electrode. FIG. 12 is a plan view of the star-shaped pin electrode 60. Its front view is shown in FIG. 13. When the star-shaped pin electrode 60 is used, it is preferred that the plastic housing groove 50 be deep enough to reach a level at which the star-shaped pin electrode 60 comes into contact with the inner wall of the column electrode 16. The pin electrode to be press-fit into its position is not particularly limited. For example, a needle-eye type pin electrode 62 shown in FIG. 14 may be used.

The relative position of the plastic housing groove 50, that is, the positional relationship between the plastic housing groove 50 and the groove formation upper mold convex, may be determined as desired as far as the aforementioned air problem can be avoided. For example, in an area where the distance between terminals is short, air is not easily trapped by the molding resin as indicated in FIG. 6. In such an instance, the plastic housing groove need not always be made between the terminals. This decision is made depending on the width of the plastic housing groove and the distance between the terminals.

The depth of the plastic housing groove 50 is not limited to the depth according to the present embodiment. More specifically, if the plastic housing groove 50 is excessively deep, the groove formation upper mold convex 51 unduly decreases the flow rate of the molding resin. If, on the contrary, the plastic housing groove 50 is excessively shallow, the groove formation upper mold convex 51 does not adequately decrease the flow rate of the molding resin. Therefore, if the above precautions are observed, the depth of the plastic housing groove 50 is not particularly limited unless the aforementioned semiconductor elements and substrate 29 are exposed to the outside.

### Third Embodiment

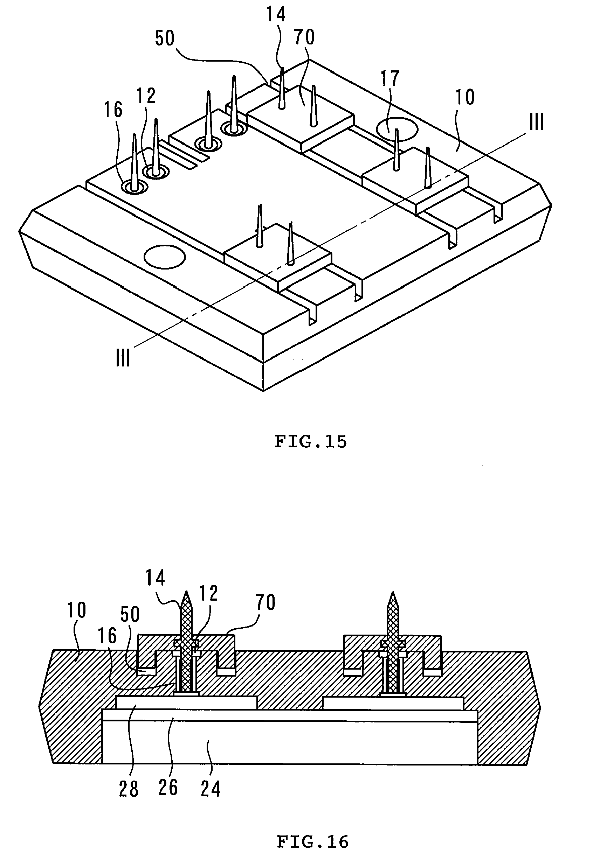

A third embodiment of the present invention will now be described with reference to FIGS. 15 and 16. FIG. 15 is a perspective external view of a power semiconductor device according to the third embodiment. The power semiconductor device according to the third embodiment, which is shown in FIG. 15, differs from the power semiconductor device according to the second embodiment in that the former includes an electrode holder 70, which covers a part of the pin electrode 14. The pin electrode 14 according to the third embodiment differs from the pin electrode according to the second embodiment in that the former has a protrusion, which is on a part covered with the electrode holder 70.

FIG. 16 is a cross-sectional view taken along line III-III in FIG. 15. As shown in FIG. 16, the electrode holder 70 covers the middle of the pin electrode 14 and determines the direction in which the pin electrode 14 is extended out of the plastic housing 10. As indicated in FIG. 16, the electrode holder 70 is shaped so that a part of it is engaged with the plastic housing groove 50. The electrode holder 70 is made of PPS (polyphenylene sulfide), which is an insulating material.

Either an outsert or insert method is used to manufacture the electrode holder 70. The outsert method is used to form the electrode holder 70 having a hole that correlates with the position of the pin electrode 14, and press-fit the electrode holder 70 over the pin electrode 14. On the other hand, the insert method is used to mold the electrode holder 70, for instance, with molding resin in such a manner as to embrace the pin electrode 14, which is glued to the column electrode 16.

No matter whether the outsert or insert method is used, it is assumed that the electrode holder 70 covers the middle of the pin electrode 14 before heat is applied to glue the column electrode 16 to the pin electrode 14 with an electrically conductive adhesive.

As indicated in FIG. 16, a portion of the pin electrode 14 that is covered with the electrode holder 70 is nonlinear and provided with a protrusion. The protrusion is not an essential element although it is provided to prevent the pin electrode 14 from being displaced from the electrode holder 70.

When a terminal of the power semiconductor device is to be connected to the outside for assembly purposes, the terminal needs to be inserted into a through-hole in an external substrate. To ensure that the terminal is properly inserted into the through-hole during an assembly process, the pin electrode needs to be connected to the column electrode in such a manner that the pin electrode is extended perpendicularly to the surface of the plastic housing. In some cases, however, the terminal may not extend perpendicularly to the surface of the plastic housing, thereby making it difficult to achieve proper assembly.

To connect the pin electrode to the column electrode in such a manner that the pin electrode extends perpendicularly to the surface of the plastic housing, however, it is necessary in some cases to keep positioning the pin electrode while a thermal process is performed to glue the pin electrode to the column electrode with an electrically conductive adhesive. Further, especially when the pin electrode serves a main electrode to handle a large current, it has an increased diameter. If it is displaced from the aforementioned through-hole in such a situation, it is difficult to achieve proper assembly.

However, the present embodiment makes it possible to avoid the aforementioned difficulty in achieving proper assembly because the electrode holder 70 ensures that the pin electrode 14 extends perpendicularly to the surface of the plastic housing 10. In other words, the electrode holder 70 according to the present embodiment functions as a positioning part.

The present embodiment assumes that an electrically conductive adhesive is used to glue the pin electrode to the column electrode. However, the advantages of the present invention are retained even when the pin electrode is press-fit into the column electrode. More specifically, when the pin electrode is individually press-fit into the column electrode, the pin electrode may be distorted. Further, when a jig is used to position the entire pin electrode for press-fitting purposes, the process may become complicated to the detriment of productivity. Under such circumstances, the present embodiment joins a plurality of pin electrodes 14 with the electrode holder 70, thereby making it possible to avoid the distortion of the pin electrodes 14 and simplify the process. Further, when the electrode holder 70 is used to perform the above-described press-fitting process, a portion of the column electrode 16 that is exposed from the plastic housing 10 may swell to form a burr or the like. However, the plastic housing concave 12 absorbs such a swell. This makes it possible to avoid unwanted interference between the electrode holder 70 and the aforementioned burr, which might occur to generate foreign matter or otherwise cause a problem when the electrode holder 70 comes into contact with the burr.

The electrode holder 70 may be additionally fixed in a direction parallel to the plastic housing groove 50 so as to enhance the accuracy with which the electrode holder 70 according to the present embodiment positions the pin electrode 14. More specifically, an alternative is to provide the plastic housing groove 50 with a concave that is formed deeper than the plastic housing groove 50, and provide the electrode holder 70 with a convex that engages with the above concave. When such a configuration is employed, the convex of the electrode holder 70 engages with the concave of the plastic housing groove 50 so that the electrode holder 70 is additionally fixed in a direction parallel to the plastic housing groove 50. This makes it possible to enhance the accuracy with which the direction of outward terminal extension is determined.

The present embodiment assumes that the electrode holder 70 is made of PPS. However, the present invention is not limited to the use of such an electrode holder. When, for instance, the pin electrode 14 is to be soldered to the column electrode 16, the electrode holder 70 may be made of any material that does not melt due to a high temperature during soldering. For example, the electrode holder 70 may be made of PEEK (polyether ether ketone). However, if a local flow soldering process is performed at a relatively low temperature, the electrode holder 70 may be made, for instance, of PBT (polybutylene terephthalate) or ABS resin.

The present embodiment may be implemented in such a manner that the electrode holder is mounted or formed on the plastic housing 10 after an adhesive, such as resin, is applied to the plastic housing concave 12. In this instance, the adhesive reinforces the connection between the column electrode 16 and pin electrode 12 and allows the electrode holder 70 to fasten to the plastic housing 10.

### Fourth Embodiment

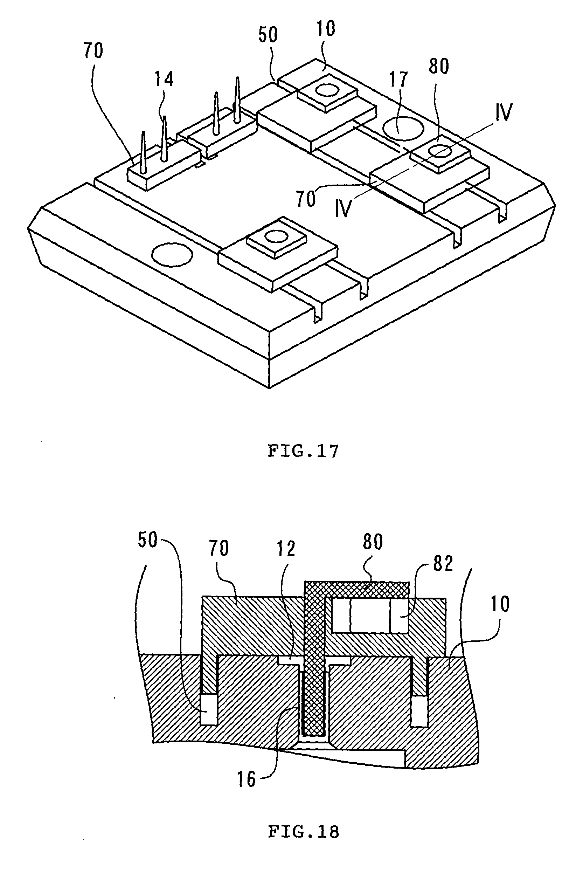

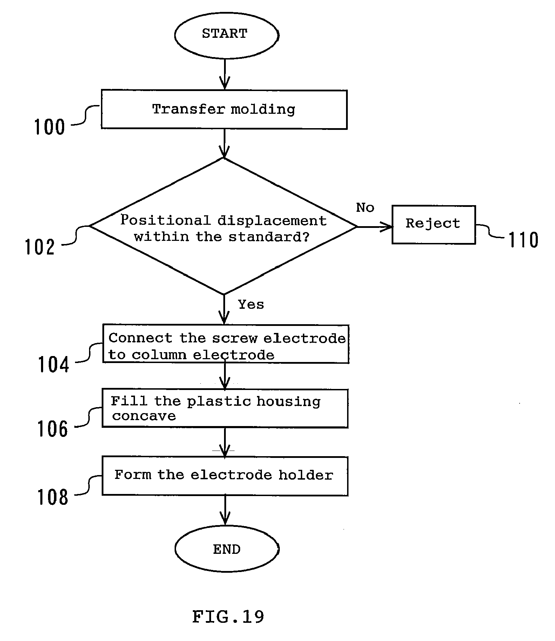

A fourth embodiment of the present invention will now be described with reference to FIGS. 17 to 19. The fourth embodiment relates to a power semiconductor device that is to be screwed down to the outside for connection purposes. FIG. 17 is a perspective external view of the power semiconductor device according to the fourth embodiment. The power semiconductor device according to the fourth embodiment, which is shown in FIG. 17, differs from the power semiconductor device according to the third embodiment in that a screw electrode 80 is connected to the column electrode instead of a pin electrode. Further, a nut is furnished to mate with the screw electrode 80. The fourth embodiment is also **characterized in that** the electrode holder 70 is provided for a pin electrode 14 that is shown in FIG. 15 and not provided with the electrode holder 70. FIG. 18 is a cross-sectional view taken along line IV-IV in FIG. 17. FIG. 19 is a flowchart illustrating a method of manufacturing the power semiconductor device according to the fourth embodiment.

The screw electrode 80 will now be described with reference to FIG. 18. The screw electrode 80 is connected to the column electrode 16 and extended out of the plastic housing 10. The screw electrode 80 is insert-formed in the electrode holder 70. A portion of the screw electrode 80 that is extended outward is provided with a hole that can be screwed down to the outside (see FIG. 17). The section of the hole in the screw electrode 80 is bent at a substantially right angle so that this hole aligns with the hole in a nut 82, which is placed in the electrode holder 70. A portion of the screw electrode 80 that is connected to the column electrode 16 is shaped like branched pins and inserted into a plurality of equipotential column electrodes 16 for connection purposes.

A terminal of a power semiconductor device that handles a large current is often screwed down, for instance, to an external bus bar for connection purposes in order to assure connection tightness and obtain an adequate capacity. For screw tightening purposes, the hole in the column electrode can be threaded to form a nut and screw down an external round crimp terminal, which is caught by the nut. In such an instance, however, an increased electrical resistance may result due to an insufficient contact area between the terminal (column electrode) and the outside, thereby generating significant heat. Consequently, it is preferred that the screw electrode 80 be exposed out of the plastic housing 10 to establish the connection by bringing a large area into contact with the outside, as is the case with the present embodiment.

When the screw electrode 80 is to be screwed down, for instance, to the aforementioned external bus bar, it is necessary to generate rotary torque. The present embodiment is configured so that the electrode holder 70 is engaged with the plastic housing groove 50. This engagement makes it possible to support the rotary torque and generate sufficient rotary torque for screw tightening. Therefore, the configuration of the present embodiment makes it possible to avoid a screw tightening failure, which occurs due to rotary torque insufficiency when the rotary torque generated by screw tightening is supported only by the joint between the column electrode and screw electrode, and prevent the joint from being damaged.

Further, when the distance between the plastic housing groove 50 and the center of the nut 82 is made longer than the distance between the column electrode 16 and the center of the nut 82, the load imposed on the column electrode 16 and screw electrode 80 decreases. Therefore, the plastic housing groove 50 and the nut 82 may be arranged as needed in consideration of the above.

Furthermore, the aforementioned rotary torque may be obtained effectively without producing a negative effect when the above-described screw tightening process is performed with an adhesive applied to the plastic housing concave 12 and plastic housing groove 50.

Another alternative for producing an intended effect is to decrease the draft angle of the plastic housing groove 50 or form a concave in a lateral surface of the plastic housing groove 50, provide the electrode holder 70 with a convex that correlates with such an undercut, and fasten the concave to the convex. Those skilled in the art will appreciate that various other modifications can be made to the present embodiment without departing from the spirit and scope of the present invention.

A method of manufacturing the power semiconductor device according to the present embodiment will now be described with reference to a flowchart in FIG. 19. First of all, a transfer molding process is performed in step 100 to form the plastic housing 10. The transfer molding process is performed while exercising control to avoid an air-induced adhesion failure as described with reference to FIGS. 8 to 10.

The positional relationship between the plastic housing concave 12 and the column electrode 16 is then observed in step 102 to judge whether the amount of positional displacement of the column electrode is in compliance with a standard. If the amount of positional displacement is not in compliance with the standard, step 110 is performed to reject the affected power semiconductor device.

If, on the other hand, the judgment result obtained in step 102 indicates that the amount of positional displacement is in compliance with the standard, step 104 is performed to connect the screw electrode 80 to the column electrode 16. This connection is established by using, for instance, an electrically conductive adhesive or a press-fitting method.

Step 106 is then performed to fill the plastic housing concave 12 with an adhesive, such as resin, for the purpose of reinforcing the connection between the column electrode 16 and the screw electrode 80.

Next, step 108 is performed to form the electrode holder 70. When the above-described manufacturing process is performed, it is possible to verify that the positional displacement of the column electrode 16 is in compliance with the standard, and manufacture the power semiconductor device that can be screwed down to the outside for connection purposes. The screw electrode described above may be replaced with a pin terminal. Further, the flowchart described above may be changed without departing from the spirit and scope of the present invention. For example, the screw electrode may be outserted into the electrode holder.

The present invention makes it easy to find the positional displacement of a terminal.

Obviously many modifications and variations of the present invention are possible in the light of the above teachings. It is therefore to be understood that within the scope of the appended claims the invention may be practiced otherwise than as specifically described.

The entire disclosure of a Japanese Patent Application No. 2009-025171, filed on February 5, 2009 including specification, claims, drawings and summary, on which the Convention priority of the present application is based, are incorporated herein by reference in its entirety.

## Claims

1. A power semiconductor device comprising:
a semiconductor element (20,22) ;
a plastic housing(10), which covers the semiconductor element(20,22) and has a plastic housing concave(12) that is formed lower than the other part of the outer wall of the plastic housing (10) ; and
a terminal(15), which is electrically connected to the semiconductor element(20,22) within the plastic housing (10) and extended from the plastic housing concave (12) to the outside of the plastic housing(10);
wherein the position of the terminal(15) within the plastic housing concave(12) gives positional displacement information about the terminal(15).

2. The power semiconductor device according to claim 1, wherein a plurality of units of the terminal(15) are disposed; and wherein the plastic housing concave (12) is formed in the outer wall of the plastic housing(10) and provided independently for each unit of the terminal.

3. The power semiconductor device according to claim 1 or 2, wherein a plurality of units of the terminal(15) are disposed; wherein each unit of the terminal(15) includes a column electrode(16), which is electrically connected to the semiconductor element(20,22), and a pin electrode(14), which is fastened to the column electrode(16) with an electrically conductive adhesive(33) and extended out of the plastic housing(10); and wherein the plastic housing concave (12) is formed in the outer wall of the plastic housing(10) and provided independently for each unit of the terminal(15).

4. The power semiconductor device according to one of claims 1 to 3, further comprising:
a heatsink(24), which is thermally connected to the semiconductor element(20,22) and exposed from a first principal surface of the plastic housing(10);
wherein a plurality of units of the terminal(15) are disposed; and
wherein each unit of the terminal(15) is extended out of a second principal surface of the plastic housing(10), which faces the first principal surface.

5. A power semiconductor device comprising:
a semiconductor element(20,22), which is disposed on a substrate (29) ;
a plastic housing(10), which covers the substrate(29) and the semiconductor element(20,22); and
a terminal(15), which is electrically connected to the semiconductor element(20,22) within the plastic housing (10) and extended from a principal surface of the plastic housing(10) to the outside of the plastic housing(10);
wherein a plastic housing groove(50), which is a groove lower than the other part, is formed in a portion of the principal surface of the plastic housing(10) that is positioned at a predetermined distance from the terminal(15);
wherein the depth of the plastic housing groove(50) is such that the substrate(29) and the semiconductor element(20,22) are not exposed to the outside; and
wherein the plastic housing groove(50) is formed by transfer molding.

6. The power semiconductor device according to claim 5, wherein the principal surface of the plastic housing(10) is provided with a plurality of units of the terminal(15); and wherein the plastic housing groove(50) is formed between one unit of the terminal(15) and another.

7. The power semiconductor device according to claim 5 or 6, wherein each unit of the terminal(15) includes a column electrode(16), which is electrically connected to the semiconductor element(20,22) and provided with a hole in a surface exposed to the outside of the plastic housing(10), and a pin electrode(60,62), which is press-fit into the hole in the column electrode(16) for connection purposes and extended out of the plastic housing(10).

8. The power semiconductor device according to one of claims 5 to 7, further comprising:
an electrode holder(70), which is disposed on a principal surface of the plastic housing(10) to cover the middle of the terminal(14) and determine the direction in which the terminal(14) is extended out of the plastic housing(10);
wherein the electrode holder(70) is insulative and partially engages with the plastic housing groove(50) or adheres to the plastic housing groove(50) for engagement purposes.

9. The power semiconductor device according to claim 8, wherein the terminal is provided with a hole for screwing down a portion of the terminal that is extended out of the plastic housing(10).

10. The power semiconductor device according to claim 9, wherein a nut(82) is embedded in the electrode holder(70); and wherein the hole in the terminal(80) is aligned with the nut.

11. A power semiconductor device manufacturing method comprising the steps of:
performing a transfer molding process to form a plastic housing concave(12), which is lower than the other part of the outer wall of a plastic housing(10), and form the plastic housing(10) so that a column electrode(16) is partially exposed from the plastic housing concave(12);
judging in accordance with the positional relationship between the plastic housing concave(12) and the column electrode(16) whether the amount of positional displacement of the column electrode(16) is in compliance with a standard; and
injecting resin or adhesive into the plastic housing concave (12) while a pin electrode(14) extended out of the plastic housing(10) is connected to the column electrode(16) so as to position a connection point within the plastic housing concave(12).
